# EUROPÄISCHE PATENTANMELDUNG

(11) **EP 4 723 172 A1**
(43) Veröffentlichungstag der Anmeldung: **08.04.2026**
(21) Anmeldenummer: 24204752.0
(22) Anmeldetag: 04.10.2024
(51) Int. Cl.: H01L 23/495, H01L 23/14, H01L 23/373, H01L 23/48, H01L 21/48, H05K 7/20

(54) **ANORDNUNG FÜR EINE ELEKTRONISCHE RECHENEINHEIT, VERFAHREN UND LEISTUNGSMODUL**

(71) Anmelder: Siemens Aktiengesellschaft, 80333 München (DE)
(72) Erfinder: HEIMANN, Matthias, 14469 Potsdam (DE); MÜLLER, Bernd, 16259 Falkenberg (DE); STENCEL, Lisa, 10117 Berlin (DE); STROGIES, Jörg, 14163 Berlin (DE)
(74) Vertreter: Siemens Patent Attorneys

(57) **Zusammenfassung**

Die Erfindung betrifft eine Anordnung für eine elektronische Recheneinheit umfassend eine metallische Trägerplatte (4), auf der eine elektrisch isolierende Schicht (6) angebracht ist, auf der ein als Einbauplatz (8) bezeichneter elektrisch leitfähiger Bereich (10) aufgebracht ist, auf dem wiederum ein elektronisches Bauelement (12) befestigt ist. Die Erfindung zeichnet sich dadurch aus, dass
- der Einbauplatz (8) mindestens zwei auf der isolierenden Schicht (6) nebeneinander vorliegende Materialbereiche (14, 16) aufweist,
- wobei ein erster Materialbereich (14) aus einem Metall besteht,
- und der zweite Materialbereich (16) aus dem Metall besteht, wobei diesem ein Legierungselement zulegiert ist.

## Beschreibung

Die Erfindung betrifft eine Anordnung für eine elektronische Recheneinheit nach Anspruch 1, ein Verfahren zur Herstellung einer solchen Anordnung nach Anspruch 11 und ein Leistungsmodul nach Anspruch 15.

In elektronischen Recheneinheiten, insbesondere in sogenannten Powermodulen, wobei leistungselektronische Bauelemente in einem Modul verbaut sind, treten einerseits häufig hohe Temperaturen und andererseits hohe Temperaturunterschiede beim Betrieb der Recheneinheit auf. Dies ist beispielsweise der Fall, wenn Leistungselektronikmodule (Powermodule) in der Motorentechnik, beispielsweise bei Elektrofahrzeugen, zum Einsatz kommen. Diese hohen Temperaturunterschiede, die jeweils in kurzer Zeit auftreten können, führen dazu, dass die Powermodule hohen thermischen Belastungen unterliegen. Insbesondere an den Einbauplätzen, an denen elektronische Bauelemente durch ein Fügeverfahren auf ein Substrat, insbesondere eine Platine oder eine Trägerplatte, befestigt sind, kommt es aufgrund von unterschiedlichen thermischen Ausdehnungskoeffizienten der einzelnen verwendeten Materialien, einerseits der elektrischen Kontaktmaterialien und andererseits des Bauelementes an sich, zu thermischen Spannungen, die über die Lebensdauer eines Powermoduls gesehen zu Rissen im Fügebereich und somit zu einem frühzeitigen Versagen des gesamten Moduls führen können. Derartige Unterschiede in dem thermischen Ausdehnungskoeffizienten beeinflussen somit negativ die Lebensdauer des gesamten Moduls.

Die Aufgabe der Erfindung besteht darin, eine Anordnung für eine elektronische Recheneinheit bereitzustellen, die gegenüber dem Stand der Technik einen besseren Ausgleich der thermischen Ausdehnungskoeffizienten einzelner Komponenten im Bereich des Einbauplatzes von elektronischen Bauelementen aufweist und somit die Lebensdauer des Moduls erhöht wird.

Die Lösung der Aufgabe besteht in einer Anordnung für eine elektronische Recheneinheit mit den Merkmalen des Patentanspruchs 1, ferner in einem Verfahren zur Herstellung einer Anordnung nach Patentanspruch 11 und in einem Leistungselektronikmodul nach Patentanspruch 15.

Die Anordnung für eine elektronische Recheneinheit nach Anspruch 1 umfasst eine metallische Trägerplatte, auf der eine elektrisch isolierende Schicht angebracht ist, auf der wiederum ein als Einbauplatz bezeichneter elektrisch leitfähiger Bereich aufgebracht ist. Auf diesem Einbauplatz ist wiederum ein elektronisches Bauelement befestigt. Die Erfindung zeichnet sich dadurch aus, dass der Einbauplatz mindestens zwei auf der isolierenden Schicht nebeneinander vorliegende Materialbereiche aufweist, wobei ein erster Materialbereich aus einem Metall besteht und der zweite Materialbereich aus dem Metall besteht, wobei diesem ein Legierungselement zulegiert ist.

Die Aufteilung des Einbauplatzes in mindestens zwei metallische und somit elektrisch leitende Bereiche, die eine unterschiedliche metallische Zusammensetzung aufweisen, führt dazu, dass zwischen den Bereichen auch ein unterschiedlicher thermischer Ausdehnungskoeffizient vorliegt. Somit kann durch das Legierungselement, das aus dem Metall zulegiert ist, der resultierende thermische Ausdehnungskoeffizient so angepasst werden, dass dieser näher an dem Ausdehnungskoeffizienten des elektronischen Bauteils liegt, als das eine bei einem herkömmlichen elektrisch leitfähigen Bereich, der üblicherweise den Einbauplatz bildet, der Fall ist. Ferner kann aber gleichzeitig ein Bereich mit einer möglichst hohen elektrischen Leitfähigkeit beibehalten werden, was für die elektrische Kontaktierung des Bauelementes wichtig ist. Durch diese Maßnahme wird lateral im Einbauplatz unterhalb des elektronischen Bauelementes der thermische Ausdehnungskoeffizient des elektrischen Bereiches sukzessive verändert, was zu einem graduierten Aufbau des Einbauplatzes führt und somit auch zu einem graduierten thermischen Ausdehnungskoeffizienten. Somit können thermisch induzierte mechanische Spannungen im Fügebereich zwischen dem elektrisch leitfähigen Bereich, also dem Einbauplatz, und dem elektronischen Bauelement kompensiert werden und gute elektrische Eigenschaften im Einbauplatz werden beibehalten. Es handelt sich bei den Maßnahmen auch um einen Kompromiss zwischen einer Optimierung der mechanischen Eigenschaften am Einbauplatz und den elektrischen Eigenschaften des selben für die Kontaktierung.

Unter dem Begriff Trägerplatte wird dabei ein insbesondere elektrisch leitendes Material, beispielsweise ein Kühlkörper oder ein sogenannter Leadframe verstanden. Auf diesem ist im Weiteren eine elektrisch isolierende Schicht aufgebracht, auf der wiederum der sogenannte Einbauplatz angeordnet ist. Der Einbauplatz bezeichnet einen elektrisch leitfähigen Bereich, der sich lateral über der elektrisch isolierenden Schicht erstreckt und diese dabei teilweise überdeckt. Dabei weist der sogenannte Einbauplatz nicht nur eine laterale Erstreckung in X-Y-Ebene bezüglich der Trägerplatte auf, sondern auch eine Erhebung in z-Richtung.

Das elektronische Bauelement ist auf diesem Einbauplatz befestigt, wobei unter dem Begriff befestigt insbesondere ein Fügeverfahren unter Zuhilfenahme eines sogenannten Fügematerials wie beispielsweise eines Lotes oder eines Sintermaterials verstanden wird. Das Fügeverfahren ist somit in der Regel ein thermisches Verfahren, beispielsweise ein Lötverfahren oder ein Sinterverfahren.

Unter dem Begriff Metall ist hierbei sowohl ein reines chemisches Element, insbesondere Silber oder Kupfer, die besonders gute elektrische und thermische Leitfähigkeiten aufweisen, verstanden. Üblicherweise werden technisch selten reine Elemente verwendet, beispielsweise wird für die besseren Fließeigenschaften, Aufbringungseigenschaften, thermischen Eigenschaften oder mechanischen Eigenschaften bestimmte Elemente dem jeweiligen Metall zulegiert. So wird beispielsweise Silber häufig mit einer Platinlegierung verwendet. Somit werden unter dem Begriff Metall auch Legierungen für übliche elektrotechnische Werkstoffe verstanden. Dieser Begriff der Legierung ist jedoch nicht identisch mit der Lehre gemäß des Patentanspruchs 1, wonach ein Legierungselement dem Metall für den zweiten Bereich zulegiert wird. Selbst wenn das Metall an sich bereits eine Legierung ist, so ist ein weiteres Legierungselement oder ein bereits im Metall Legierungselement vorliegendes, dann in einer höheren Konzentration als im ersten Bereich dem Metall im zweiten Bereich zulegiert. Der Unterschied zwischen dem Metall im ersten Bereich und dem Metall im zweiten Bereich besteht insbesondere darin, dass der zweite Bereich von einem Legierungselement (ungeachtet dessen, ob dieses Legierungselement bereits im Metall des ersten Bereichs vorliegt) mit einer erhöhten Konzentration vorliegt.

Durch die Konzentrationserhöhung des Legierungselementes wird zwar einerseits im Falle von Kupfer oder Silber die elektrische Leitfähigkeit verschlechtert, aber es wird auch der Ausdehnungskoeffizient des Materials verändert. In der Regel wird dieser verringert. Als Legierungselemente zu dem Metall, insbesondere dem Kupfer oder dem Silber, bieten sich Molybdän oder Wolfram an. Diese beiden Elemente sind einerseits ein guter Kompromiss, was die Veränderung des thermischen Ausdehnungskoeffizienten in Richtung der Werte des elektronischen Bauelementes einerseits und andererseits der noch guten elektrischen Leitfähigkeit angeht.

In einer weiteren Ausgestaltungsform der Erfindung ist ein dritter Bereich vorgesehen, der dasselbe Legierungselement aufweist wie der zweite Bereich, jedoch in einer weiter erhöhten Konzentration. Dies führt dazu, dass sich vom zweiten Bereich zum dritten Bereich der thermische Ausdehnungskoeffizient der verwendeten Materialien weiter verändert und somit durch den zusätzlich eingebrachten dritten Bereich eine gezieltere stufenförmigere Anpassung des Ausdehnungskoeffizienten über den Einbaubereich erzielt werden kann. Grundsätzlich können selbstverständlich noch mehrere Bereiche mit weiter erhöhten Konzentrationen des Legierungselements angeordnet sein. Die Anzahl der verwendeten Bereiche im Einbaubereich hängt dabei von dem zu überwindenden sogenannten Mismatch zwischen dem Ausdehnungskoeffizienten des Metalls und des elektronischen Bauelementes sowie dem zu erwartenden Temperaturunterschied während des Betriebes ab. Diese Anforderungsdaten führen dann dazu, dass sowohl die Konzentration des zu legierenden Legierungselementes und die Anzahl der Bereiche und wiederum deren Ausdehnung bevorzugt durch ein Simulationsverfahren bei der Konstruktion der Anordnung ermittelt werden. Dabei ist es erstrebenswert, so wenig wie möglich unterschiedliche Bereiche nutzen zu müssen, da die Herstellungskosten geringer ausfallen, wenn weniger Prozessschritte angewendet werden.

In einer weiteren Ausgestaltungsform der Erfindung ist der erste Bereich im Zentrum des Einbauplatzes angeordnet und vom zweiten Bereich und/oder je nach Vorhandensein vom dritten Bereich umgeben. Dabei ist es insbesondere zweckmäßig, wenn der zweite bzw. der zweite und dritte Bereich den ersten Bereich konzentrisch umgeben, da diese in alle Richtungen der Einbauebene, der sogenannten X-Y-Richtung, die harmonischste Verteilung des thermischen Ausdehnungskoeffizienten hervorbringt.

Ferner kann es zweckmäßig sein, dass weitere Bereiche über dem ersten Bereich, dem zweiten Bereich und/oder sofern vorhanden, dem dritten Bereich und weiteren Bereichen angeordnet sind. Auf diese Weise können, wenn die weiteren Bereiche ebenfalls ein gleiches oder anderes Legierungselement umfassen, ein thermischer Ausdehnungskoeffizient des gesamten Einbaubereiches in Z-Richtung angepasst werden.

In einer weiteren Ausgestaltungsform der Erfindung ist das elektronische Bauelement insbesondere ein leistungselektronisches Bauelement und die elektronische Recheneinheit ein Leistungselektronikmodul. Insbesondere bei einer Leistungselektronik fallen hohe Temperaturschwankungen, Temperaturzyklen und hohe Temperaturen an sich an, sodass die beschriebene Erfindung hier besonders wirksam ist.

Ein weiterer Bestandteil der Erfindung ist ein Verfahren zur Herstellung einer Anordnung für eine elektronische Recheneinheit, wobei auf eine metallische Trägerplatte eine elektrisch isolierende Schicht aufgebracht wird, diese wird anschließend thermisch verfestigt. Im Weiteren wird mittels eines Druckverfahrens ein Einbauplatz für ein elektrisches Bauelement in Form eines elektrisch leitfähigen Bereichs aufgebracht. Dieser elektrisch leitfähige Bereich des Einbauplatzes weist dabei zunächst einen ersten Bereich auf, der mittels einer ersten Druckpaste aufgebracht bzw. aufgedruckt wird, wobei diese erste Druckpaste als funktionalen Bestandteil ein Metall enthält. Ferner folgt ein zweiter Bereich, mittels einer zweiten Druckpaste, der neben dem ersten Bereich in lateraler Richtung aufgebracht wird und diese zweite Druckpaste weist als funktionalen Bestandteil ebenfalls das Metall auf, zu dem ein Legierungselement zulegiert ist. Des Weiteren erfolgt ein thermisches Verfestigen der Druckpaste, wonach ein s elektronischen Bauelement auf dem so erzeugten Einbauplatz aufgebracht wird. Das beschriebene Verfahren weist dabei die gleichen Vorteile auf, die bereits bezüglich der Anordnung beschrieben sind (es gelten dieselben Definitionen). Die Aufbringung von mindestens zwei Bereichen am Einbauplatz, die unterschiedliche Legierungszusammensetzungen aufweisen, führt dazu, dass sich der thermische Ausdehnungskoeffizient über die Fläche des Einbaubereichs, der sogenannten X-Y-Richtung, gradientenförmig verändert und somit sich über diese Fläche dem Ausdehnungskoeffizienten des elektronischen Bauelementes anpasst, wodurch ein sogenannter Mismatch im thermischen Ausdehnungskoeffizienten reduziert bzw. minimiert wird, was wiederum zu einer höheren Lebensdauer des elektronischen Bauelementes und der Anordnung bzw. eines Powermoduls führt.

Besonders vorteilhaft ist es dabei, wenn das Metall, das für den funktionalen Bestandteil der Druckpaste steht, Kupfer oder Silber oder eine technische Legierung hieraus ist. Das Legierungselement ist dabei wiederum bevorzugt Molybdän oder Wolfram, da diese den thermischen Ausdehnungskoeffizienten des Kupfers bzw. des Silbers entsprechend verändern, sodass der Mismatch reduziert wird.

Ein weiterer Bestandteil der Erfindung ist ein leistungselektronisches Modul, das eine Anordnung nach einem der Ansprüche 2 bis 10 oder eine Anordnung, hergestellt nach einem der Ansprüche 11 bis 14, umfasst.

Weitere Merkmale der Erfindung und weitere Ausgestaltungsformen werden anhand der folgenden Figuren näher erläutert. Dabei handelt es sich um rein schematische Ausgestaltungen, die keine Einschränkung des Schutzbereiches darstellen. Dabei zeigen:
- Figur 1: eine schematische Darstellung der Abfolge der Prozessschritte zur Herstellung einer Anordnung mit einem Einbauplatz und einem elektronischen Bauelement,
- Figur 2: eine analoge Abfolge gemäß Figur 1 mit mehreren übereinander gelagerten Bereichen im Einbaubereich,
- Figur 3: eine Draufsicht auf eine Trägerplatte mit Einbaubereichen und elektronischen Bauelementen,
- Figur 4: einen Querschnitt durch die Darstellung in Figur 3 oben und
- Figur 5: einen Querschnitt durch die Darstellung in Figur 3 unten.

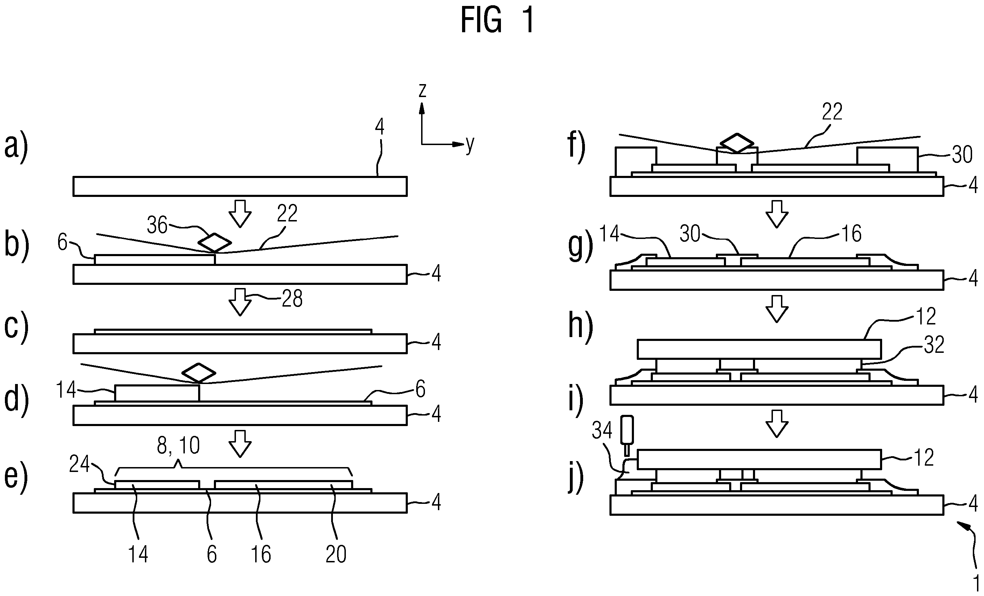

In Figur 1 ist zunächst eine Trägerplatte 4 abgebildet. Hierbei handelt es sich in der Regel um eine metallische Trägerplatte 4, beispielsweise einen Kühlkörper oder einen sogenannten Leadframe (Fig. 1a). Das beschriebene Verfahren und die beschriebene Anordnung sind somit dafür geeignet, einen Einbauplatz 8 für ein elektronisches Bauelement 12 auf eine metallische Trägerplatte 4 zu erzeugen. Hierzu wird zunächst wie in Figur 1 zu erkennen ist, eine elektrisch isolierende Schicht 6 mittels eines Druckverfahrens 22 aufgebracht (Fig. 1 b). Unter einem Druckverfahren wird insbesondere ein Schablonendruckverfahren, unter das auch ein sogenanntes Siebdruckverfahren fällt, verstanden. Hierbei wird eine hier nicht dargestellte Druckpaste mittels eines Rakels 36 durch eine Schablone, die auch Teil eines Siebes sein kann (Siebdruckverfahren) gepresst und auf dem Substrat in Form der Trägerplatte 4 abgedruckt. Somit kann eine flächige dreidimensionale Struktur erzeugt werden, die beispielsweise eine Schichtdicke von 20 bis 200 µm aufweisen kann. Die Schichtdicke wird hierbei durch den Rakeldruck bzw. die Rakelgeschwindigkeit und die Viskosität der Druckpaste erzeugt.

Des Weiteren erfolgt ein thermischer Prozess 28 (Fig. 1 c), der insbesondere einen Trocknungsprozess und im Weiteren einen Brennprozess, beispielsweise einen Sinterprozess umfasst. Hierbei wird die aufgetragene Druckpaste getrocknet und verfestigt. Auf diese Weise ist die elektrisch isolierende Schicht 6 fertiggestellt.

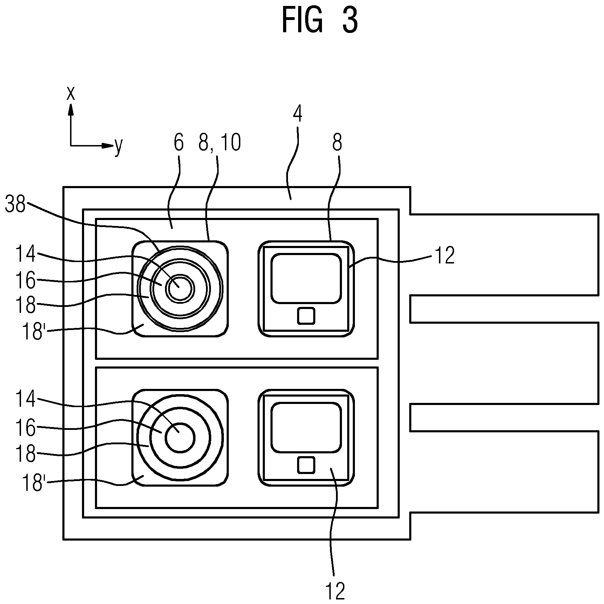

Auf diese elektrisch isolierende Schicht 6 wird nun im Weiteren ebenfalls mit einem Druckverfahren 28 ein Einbauplatz in Form eines elektrisch leitfähigen Bereichs 10 aufgebracht. Hierbei wird zunächst eine Druckpaste verwendet, in diesem Fall zunächst eine erste Druckpaste 24 mittels des Druckverfahrens 22 aufgebracht. Dies ist in Figur 1 d veranschaulicht. Im Weiteren folgt gemäß Figur 1 e das Aufbringen eines zweiten Bereichs 16 mit einer zweiten Druckpaste 26, die dann in dieser Ausgestaltungsform zusammen den Einbauplatz 8 über der elektrisch isolierenden Schicht 6 auf der Trägerplatte 4 bilden und somit den elektrisch leitfähigen Bereich 10 darstellen. Es können auch noch ein Dritter und weitere Bereiche 18, 18" wie in Figuren 3 bis 5 veranschaulicht, vorgesehen sein.

Dabei weist die erste Druckpaste 24 neben organischen und flüssigen Substanzen, die zur Gewährleistung der rheologischen Eigenschaften der Paste 24 (gleiches gilt für Paste 26) dienen noch einen funktionalen metallischen Bestandteil auf. Dieser funktionale metallische Bestandteil ist in der Regel in Form eines Metallpulvers ausgestaltet, wobei das Metallpulver insbesondere Kupfer oder Silber oder eine Legierung dieser Elemente ist. Eine besonders hohe elektrische Leitfähigkeit weist möglichst reines Kupfer auf, das auch in der Elektrotechnik häufig für die Metallisierung angewandt wird. Somit weist das hier verwendete Kupfer in der ersten Paste 24 einen mindestens 98 %-ige Reinheit für den ersten Bereich 14 auf. Die zweite Paste 26 für den zweiten Bereich 16 umfasst dabei als metallisches Pulver eine Kupferlegierung, die zu 10 Gew. % Molybdän umfasst. Durch die Zugabe von Molybdän wird der thermische Ausdehnungskoeffizient des Kupfers verkleinert. Kupfer hat in Reinform etwa einen Ausdehnungskoeffizienten von 18 ppm/K, welche durch die Zugabe von Molybdän in bestimmten Legierungszusammensetzungen auf einen Wert zwischen 6 und 11 ppm/K reduziert wird. Eine ähnliche Reduzierung des Ausdehnungskoeffizienten wird durch die Zumischung von Wolfram zu Kupfer erzeugt. Hierbei liegt nun der Ausdehnungskoeffizient der Legierung aus Kupfer und Wolfram bzw. Kupfer und Molybdän deutlich näher an den von typischen Halbleitermaterialien, wie beispielsweise den Galliumarsenid (6 ppm/K), Galliumnitrid (5 bis 6 ppm/K), Aluminiumnitrid (4 ppm/K) oder Siliciumcarbid (4 ppm/K). Auf diese Weise kann auch weiterhin als elektrisch leitfähiges Material das reine oder nahezu reine Kupfer oder Silber verwendet werden, das für die elektrische Kontaktierung besonders vorteilhaft ist und dabei auch eine hohe Wärmeleitfähigkeit aufweist. Andererseits weisen Legierungen von Kupfer mit Molybdän ebenfalls noch eine gute elektrische Leitfähigkeit auf und durch den Übergang von verschiedenen Bereichen 14, 16 und 18 kann somit der thermische Ausdehnungskoeffizient ausgehend von Kupfer sukzessive erniedrigt werden, bis dieser den Wert des verwendeten Halbleitermaterials nahezu angeglichen ist.

In den weiteren Unterfiguren der Figur 1 wird nun die Fertigstellung der Anordnung 2 weiter beschrieben. Neben dem so erzeugten Einbauplatz 8 wird eine weitere Isolationsschicht 30 aufgebracht, dies erfolgt wiederum bevorzugt durch ein Druckverfahren und ein weiteres thermisches Verfahren von Trocknung und Brennen bzw. Sintern. Des Weiteren wird ein Fügematerial 32 aufgebracht, auf das wiederum das elektronische Bauteil 12 aufgesetzt und gefügt wird. Beim Fügeverfahren kann beispielsweise ein Lotverfahren oder ein Sinterverfahren zum Einsatz kommen. Gegebenenfalls kann auch eine Unterfüllung mittels eines Unterfüllungsmaterials 34 des von Hohlräumen zwischen dem Bauelement 12 und dem Einbauplatz 8 erfolgen.

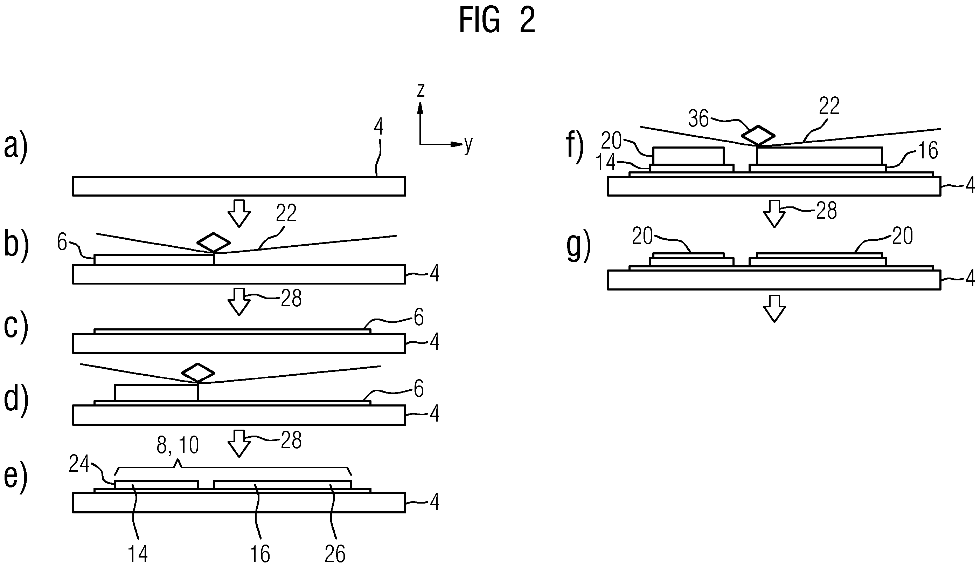

In Figur 2 ist eine analoge Ausgestaltung der Schritte gemäß Figur 1 dargelegt. Diese gleicht der Figur 1 in den Schritten a bis e, im Schritt f wird ein weiterer Bereich 20 in Z-Richtung auf den ersten Bereich 14 aufgebracht. Der Bereich 20 kann dabei ebenfalls ein Legierungselement wie beispielsweise Wolfram oder Molybdän umfassen, um auch in Z-Richtung den thermischen Ausdehnungskoeffizienten zwischen dem Einbaubereich 8 und dem elektronischen Bauteil 12 auszugleichen.

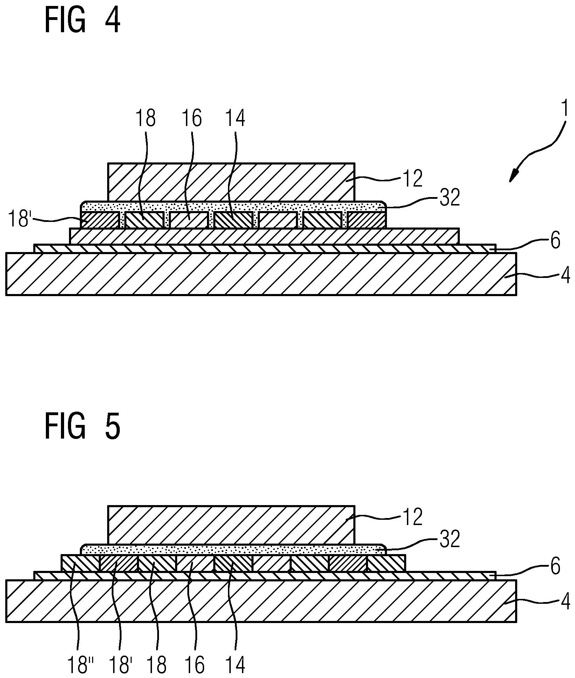

In Figur 3 ist eine Draufsicht auf eine Trägerplatte 4 gegeben, auf der mehrere elektrisch leitfähige Bereiche 10 in Form von Einbauplätzen 8 für elektronische Bauelemente 12 dargestellt sind. Im oberen Bereich ist der Einbauplatz 8, der auf der elektrisch isolierenden Schicht 6 angeordnet ist, in mehrere Bereiche 14, 16 und 18 unterteilt. Hierbei liegt eine Unterteilung in diesem Fall konzentrischen Kreisen vor, wobei der mittlere Kreis durch den Bereich 14 gebildet wird, der im Wesentlichen aus Kupfer oder einer möglichst reinen Kupferlegierung besteht. Der darauffolgende Bereich 16, der zweite Bereich, umfasst eine Legierung von Kupfer und 10 % Molybdän, der nächste konzentrische Bereich 18, der dritte Bereich 18, umfasst dabei Kupfer mit 20 Gewichts-% Molybdän. Es können noch weitere Bereich 18` bzw. 18" vorgesehen sein, um einen möglichst gleichmäßigen gradientenförmigen Aufbau des so resultierenden thermischen Ausdehnungskoeffizienten in der X-Y-Ebene zu erzeugen. Ein Querschnitt durch diesen gerade beschriebenen Aufbau in Figur 3 oben ist in Figur 4 veranschaulicht. Hierbei ist zu erkennen, dass zwischen den einzelnen konzentrischen Bereichen 14, 16, 18 und 18' jeweils ein kleiner Spalt bestehen bleibt, der im Querschnitt gemäß Figur 4 mit einem Fügematerial 32, beispielsweise einem Lotmaterial, ausgefüllt ist. Dieser Spalt kann bei bestimmten Anwendungen ebenfalls zum Ausgleich des Wärmeausdehnungskoeffizienten zweckmäßig sein. Der untere Bereich der Figur 3 ist im Querschnitt in Figur 5 dargestellt, hier liegen keine Spalte zwischen den einzelnen Bereichen, 14, 16, 18 und 18' vor. Dabei ist anzumerken, dass das Drucken der Bereiche 14 bis 18 mittels der Schablone und unterschiedlichen Pasten 24, 26 direkt nacheinander erfolgen kann bzw. können auch nach jedem einzelnen Druckschritt ein Trocknungsschritt und ein Brennschritt bzw. Sinterschritt erfolgen.

### Bezugszeichenliste

- 2: Anordnung
- 4: Trägerplatte
- 6: el. isolierende Schicht
- 8: Einbauplatz
- 10: el. leitfähiger Bereich
- 12: elektronisches Bauelement
- 14: erster Materialbereich
- 16: zweiter Materialbereich
- 18: dritter Bereich
- 20: weitere Bereiche
- 22: Druckverfahren
- 24: erste Druckpaste
- 26: zweite Druckpaste
- 28: thermisches Verfahren
- 30: weitere Isolationsschicht
- 32: Fügematerial
- 34: Unterfüllmaterial
- 36: Rakel
- 38: Spalte

## Patentansprüche

1. Anordnung für eine elektronische Recheneinheit umfassend eine metallische Trägerplatte (4), auf der eine elektrisch isolierende Schicht (6) angebracht ist, auf der ein als Einbauplatz (8) bezeichneter elektrisch leitfähiger Bereich (10) aufgebracht ist, auf dem wiederum ein elektronisches Bauelement (12) befestigt ist, **dadurch gekennzeichnet, dass**
- der Einbauplatz (8) mindestens zwei auf der isolierenden Schicht (6) nebeneinander vorliegende Materialbereiche (14, 16) aufweist,
- wobei ein erster Materialbereich (14) aus einem Metall besteht,
- und der zweite Materialbereich (16) aus dem Metall besteht, wobei diesem ein Legierungselement zulegiert ist.

2. Anordnung nach Anspruch 1, **dadurch gekennzeichnet, dass** das Metall Kupfer oder Silber oder eine deren Legierungen ist.

3. Anordnung nach Anspruch 1 oder 2, **dadurch gekennzeichnet, dass** das Legierungselement Molybdän oder Wolfram ist.

4. Anordnung nach einem der Ansprüche 1 bis 3, **dadurch gekennzeichnet, dass** ein dritter Bereich (18) vorgesehen ist, der dasselbe Legierungselement aufweist, wie der zweite Bereich (16), jedoch in einer höheren Konzentration.

5. Anordnung nach einem der vorhergehenden Ansprüche, **dadurch gekennzeichnet, dass** der erste Bereich im Zentrum des Einbauplatzes (8) angeordnet ist und vom zweiten Bereich (16) und/ oder dritten Bereich (18) umgeben ist.

6. Anordnung nach Anspruch 5, **dadurch gekennzeichnet, dass** der erste Bereich (14) vom zweiten Bereich (16) und/oder dritten Bereich (18) konzentrisch umgeben ist.

7. Anordnung nach einem der vorhergehenden Ansprüche, **dadurch gekennzeichnet, dass** weitere Bereiche (20) über dem ersten Bereich (14), zweiten Bereich (16) und/oder dritten Bereich (18) angeordnet sind.

8. Anordnung nach Anspruch 7, **dadurch gekennzeichnet, dass** die weiteren Bereiche (20) das Legierungselement umfassen.

9. Anordnung nach einem der vorhergehenden Ansprüche, **dadurch gekennzeichnet, dass** das elektronische Bauelement (12) ein leistungselektronisches Bauelement ist.

10. Anordnung nach einem der vorhergehenden Ansprüche, **dadurch gekennzeichnet, dass** die die elektronische Recheneinheit (2) ein Leistungselektronik-Modul ist.

11. Verfahren zur Herstellung einer Anordnung (2) für eine elektronische Recheneinheit (2), wobei
- auf eine metallische Trägerplatte (4) eine elektrisch isolierende Schicht (6) aufgebracht wird,
- diese anschließend thermisch verfestigt wird,
- im Weiteren mittels eines Druckverfahrens (22) ein Einbauplatz (8) für ein elektronisches Bauelement (12) in Form eines elektrisch leitfähigen Bereichs (10) aufgebracht,
- wofür ein erster Bereich (14) mittels einer ersten Druckpaste (24) aufgebracht wird, die als funktionaler Bestandteil ein Metall enthält, und
- ein zweiter Bereich (16) mittels einer zweiten Druckpaste (26) aufgebracht wird, die als funktionaler Bestandteil das Metall mit einem zulegierten Legierungselement enthält,
- thermisches Verfestigen der Druckpasten (24, 26) und
- Aufbringen eines elektronischen Bauelementes (12) auf den so erzeugten Einbauplatz (8).

12. Verfahren nach Anspruch 11, **dadurch gekennzeichnet, dass** das Metall Kupfer oder Silber oder eine deren Legierungen ist.

13. Verfahren nach Anspruch 11 oder 12, **dadurch gekennzeichnet, dass** das Legierungselement Molybdän oder Wolfram ist.

14. Verfahren nach einem der Ansprüche 11 bis 13, **dadurch gekennzeichnet, dass** ein dritter Bereich (18) aufgebracht wird, der dasselbe Legierungselement aufweist, wie der zweite Bereich (16), jedoch in einer höheren Konzentration.

15. Leistungselektronik-Modul umfassend eine Anordnung (2) nach einem der Ansprüche 2 bis 10 oder eine Anordnung (2) hergestellt, nach einem der Ansprüche 11 bis 14.
